# EUROPÄISCHE PATENTSCHRIFT

(11) **EP 2 290 753 B1**
(45) Veröffentlichungstag und Bekanntmachung des Hinweises auf die Patenterteilung: **05.12.2012**
(21) Anmeldenummer: 09011143.6
(22) Anmeldetag: 31.08.2009
(51) Int. Cl.: H05K 1/02, H01R 12/72

(54) **Steckverbinder und Multilayerplatine**
Connector and multilayer circuit board
Connecteur et platine multicouche

(43) Veröffentlichungstag der Anmeldung: 02.03.2011
(73) Patentinhaber: ERNI Electronics GmbH, 73099 Adelberg (DE)
(72) Erfinder: Lappöhn, Jürgen, 73108 Gammelshausen (DE)
(74) Vertreter: Jakelski & Althoff

(56) Entgegenhaltungen:
- DE-A1- 19 604 432
- DE-A1-102007 060 429
- US-B1- 6 817 870

## Beschreibung

### Stand der Technik

Die Erfindung geht aus von einem mehrpoligen Steckverbinder zur Kontaktierung mit einer Multilayerplatine, von einer Multilayerplatine zur Bestückung mit einem mehrpoligen Steckverbinder und von einer Kombination aus einem mehrpoligen Steckverbinder und einer zur Bestückung mit dem Steckverbinder vorgesehenen Multilayerplatine.

### Stand der Technik

Aus der US 6 817 870 B1 ist eine Multilayerplatine bekannt geworden zur Bestückung mit einem mehrpoligen Steckverbinder, die Sacklochbohrungen zur Kontaktierung von Anschlussstiften der Kontaktelemente des mehrpoligen Steckverbinders aufweist, wobei die Sacklochbohrungen in unterschiedlichen Leiterbahnebenen der Multilayerplatine zur gezielten Kontaktierung der Anschlussstifte der Kontaktelemente mit in unterschiedlichen Leiterbahnebenen vorgesehenen Leiterbahnen der Multilayerplatine enden. Darüber hinaus offenbart dieses Dokument eine Kombination dieser Multilayerplatine mit einem mehrpoligen Steckverbinder, wobei die Anschlussstifte der Kontaktelemente des Steckverbinders unterschiedlich lang sind zur Kontaktierung der Anschlussstifte mit in unterschiedlichen Leiterbahnebenen vorgesehenen Leiterbahnen der Muttilayerplatine. Die Sacklochbohrungen in unterschiedlichen Leiterbahnebenen der Multilayerplatine enden zur gezielten Kontaktierung der in der Länge angepassten Anschlussstifte der Kontaktelemente in unterschiedlichen Leiterbahnebenen der Multilayerplatine.

In der Offenlegungsschrift DE 100 40 303 A1 ist ein Verfahren zum definierten Tiefenbohren von Sacklöchern in Multilayer-Platinen beschrieben. Vorgesehen sind Testbohrungen, bei denen die exakte Tiefe der jeweiligen Leiterbahnschicht dadurch ermittelt wird, dass ein Stromfluss detektiert wird, sobald die Bohrerspitze die Leiterbahnschicht erreicht. Die Detektion von in Bohrrichtung hintereinander liegenden Leiterbahnschichten wird dadurch zuverlässig möglich, dass von Leiterbahnschicht zu Leiterbahnschicht jeweils Bohrer mit geringerem Bohrdurchmesser verwendet werden, sodass Kurzschlüsse zwischen verschiedenen Leiterbahnschichten vermieden werden.

Die Offenlegungsschrift DIE 199 02 950 A1 beschreibt die Herstellung einer Leiterplatte, die von beiden Seiten mit Steckverbindern bestückt werden kann. Die Leiterplatte wird aus zwei Multilayer-Leiterplatten zusammengesetzt, die miteinander verklebt werden. Die beiden Leiterplatten enthalten eine Vielzahl von durchkontaktierten Bohrungen, die durch die Leiterbahnen der Multilayerplatine miteinander In Verbindung stehen. Die durchkontaktierten Bohrungen sind zur Aufnahme der Anschluss-Stifte der Steckverbinder vorgesehen. Die Anschluss-Stifte werden in die Bohrungen eingepresst, wodurch die elektrische und gleichzeitig die mechanische Verbindung mit den Bohrungen hergestellt werden soll.

Die im Gebrauchsmuster DE 296 01 655 U1 beschriebene Leiterplatte, die ebenfalls zur beidseitigen Kontaktierung mit Steckverbindern vorgesehen ist, wird ebenso aus zwei zusammenzuklebenden Multilayer-Leiterplatten hergestellt. Die Anschluss-Stifte der Steckverbinder sind in den Bohrungen eingepresst, die als Sacklöcher realisiert sein können.

Die in der Offenlegungsschrift DE 40 02 025 A1 beschriebene Multilayerplatine enthält Durchkontaktierungen in Form von durchgehend leitend beschichteten Wandungen von Bohrungen, welche Kontaktierungspunkte mit ausgewählten Leiterbahnschichten der Multilayer-Platine aufweisen. Die Durchkontaktierungen weisen am oberen Ende einen Bereich mit einem erhöhten Querschnitt auf. Der erhöhte Querschnitt ist in mindestens einer separaten auflaminierten Deckplatte herausgebildet. Die Bereiche mit dem erhöhten Querschnitt sind zur Aufnahme von Anschluss-Stiften von Steckverbindern vorgesehen. Einige der Bohrungen können auch blind sein, um zu vermeiden, dass sie mit unter ihnen liegenden Leiterbahnschichten kurzgeschlossen werden.

In der Patentschrift DE 699 15 882 T2 ist ein Steckverbinder beschrieben, der für eine hochfrequente Datenübertragung geeignet ist. Jedem Signal führenden Kontaktelement ist ein abschirm- beziehungsweise Massepotenzial führendes Kontaktelement zugeordnet. Die Ausrichtung der Kontaktelemente ist derart getroffen, dass eine Impedanz-Anpassung ermöglicht wird.

In der Patentschrift US 6 976 886 B2 ist ein Steckverbinder beschrieben, bei dem durch eine spezielle Anordnung und Ausrichtung der Signal führenden und abschirm- beziehungsweise Massepotenzial führenden Kontaktelemente zueinander eine hohe Abschirmwirkung der Signal führenden Leitungen gegeneinander und des Steckverbinders insgesamt erreicht werden soll. Der bekannte Steckverbinder ist speziell für hochfrequente Signale geeignet, wobei die Anordnung der Signal führenden und Massepotenzial führenden Kontaktelemente darüber hinaus zur Erzielung eines bestimmten Wellenwiderstands speziell vorgegeben ist.

In der Offenlegungsschrift DE 198 07 713 A1 ist ein Steckverbinder beschrieben, der eine große Anzahl von Kontaktelementen enthält. Der bekannte Steckverbinder ist zum Herstellen von Steckverbindungen zwischen Backplanes und Einschubkarten vorgesehen, wobei im konkreten Ausführungsbeispiel Steckverbindungen zwischen Backplanes und Einschubkarten sogenannter Compact-PCI-Systeme hergestellt werden

In dem Fachbuch von Meinke und Gundlach "Taschenbuch für Hochfrequenztechnik", Springer-Verlag 1956, sind Grundbegriffe der Elektrotechnik wie Kapazität, Induktivität und Wellenwiderstand erläutert.

Der Erfindung liegt die Aufgabe zugrunde, einen mehrpoligen Steckverbinder zur Kontaktierung mit einer Multilayerplatine, eine Multilayerplatine zur Bestückung mit einem mehrpoligen Steckverbinder sowie eine Kombination aus einem mehrpoligen Steckverbinder und einer zur Bestückung mit dem mehrpoligen Steckverbinder vorgesehenen Multilayerplatine jeweils anzugeben, die eine Führung von Signalen mit sehr hohen Frequenzen, insbesondere von Digitalsignalen, ermöglichen.

Die Aufgabe wird durch die in den unabhängigen Ansprüchen angegebenen Merkmale jeweils gelöst.

### Offenbarung der Erfindung

Der mehrpolige Steckverbinder zur Kontaktierung mit einer Multilayerplatine geht von einer Vielzahl von in Kontaktelementreihen angeordneten Kontaktelementen aus, wobei die Anschlussstifte der in einer Kontaktelementreihe liegenden Kontaktelemente jeweils gleich lang sind. Der erfindungsgemäße Steckverbinderist dadurch gekennzeichnet, dass die Anschlussstifte der Kontaktelemente zur Kontaktierung mit in unterschiedlichen Leiterbahnebenen vorgesehenen Leiterbahnen der Multilayerplatine von Kontaktelementreihe zu Kontaktelementreihe in Stufen jeweils weniger lang enden. Hierdurch werden Signal-Laufzeitdifferenzen zwischen Differenzsignalen wirksam vermieden.

Bei der Multilayerplatine zur Bestückung mit einem mehrpoligen Steckverbinder, die in Reihen angeordnete Sacklochbohrungen zur Kontaktierung von Anschluss-Stiften der in Kontaktelementreihen angeordneten Kontaktelemente des mehrpoligen Steckverbinders sowie in unterschiedlichen Leiterbahnebenenen vorgesehenen Leiterbahnen aufweist, zeichnet sich dadurch aus, dass die Sacklochbohrungen zur gezielten Kontaktierung der Anschlussstifte der in Kontaktelementreihen angeordneten Kontaktelemente abgestuft von Reihe zu Reihe unterschiedlich tief sind und in unterschiedlichen Leiterbahnebenen der Multilayerplatine enden.

Die erfindungsgemäße Kombination aus mehrpoligem Steckverbinder und Multilayerplatine, wobei der Steckverbinder eine Vielzahl von in Kontaktelementreihen angeordneten Kontaktelementen aufweist, wobei die Anschlussstifte der in einer Kontaktelementreihe liegenden Kontaktelemente jeweils gleich lang sind, und die Multilayerplatine in Reihen angeordnete Sacklochbohrungen zur Kontaktierung von Anschlussstiften der in den Kontaktelementreihen angeordneten Kontaktelemente des mehrpoligen Steckverbinders sowie in unterschiedlichen Leiterbahnebenen vorgesehenen Leiterbahnen aufweist, ist dadurch gekennzeichnet, dass die Anschlusstifte der Kontaktelemente zur Kontaktierung mit in unterschiedlichen Leiterbahnebenen vorgesehenen Leiterbahnen der Multilayerplatine von Kontaktelementreihe zu Kontaktelementreihe in Stufen jeweils weniger lang enden und dadurch, dass die Sacklochbohrungen zur gezielten Kontaktierung der Anschlussstifte der in Kontaktelementreihen angeordneten Kontaktelemente abgestuft von Reihe zu Reihe unterschiedlich tief sind und in unterschiedlichen Leiterbahnebenen der Multilayerplatine enden.

Der erfindungsgemäße mehrpolige Steckverbinder, die erfindungsgemäße Multilayerplatine sowie die erfindungsgemäße Kombination aus dem mehrpoligen Steckverbinder und der Multilayerplatine ermöglichen zunächst eine hohe Dichte von Kontaktelementen des Steckverbinders. Erreicht wird dies durch eine entsprechend hohe Dichte von Leiterbahnen in der Multilayerplatine, die zur Kontaktierung mit den Anschluss-Stiften der Kontaktelemente des Steckverbinders zur Verfügung stehen.

Ein wesentlicher Vorteil ergibt sich dadurch, dass die in den unterschiedlichen Leiterbahnebenen geführten Leiterbahnen der Multilayerplatine nunmehr eine einfache geometrische Ausgestaltung aufweisen können. Insbesondere können sämtliche Leiterbahnen in gerader Linie ohne Ausweichkurven von den Anschluss-Stiften der Kontaktelemente des Steckverbinders weggeführt werden. Dadurch eignet sich der erfindungsgemäße mehrpolige Steckverbinder, die erfindungsgemäße Multilayerplatine sowie die erfindungsgemäße Kombination aus dem mehrpoligen Steckverbinder und der Multilayerplatine für sehr hohe Frequenzen der über die Kontaktelemente des Steckverbinders zu führenden Signale, die bei Digitalsignalen bis zu 40 GigaBit/s betragen können, ohne dass die Dämpfung zu groß wird beziehungsweise das Augenmuster der Digitalsignale zusammenklappt.

Der erfindungsgemäße mehrpolige Steckverbinder, die erfindungsgemäße Multilayerplatine sowie die erfindungsgemäße Kombination aus dem mehrpoligen Steckverbinder und der Multilayerplatine sind besonders in einer Anwendung geeignet, bei welcher die Multilayerplatine als Backplane oder bei welcher die Multilayerplatine zum Kontaktieren mit einer Backplane eingesetzt ist. Mit dieser Technik werden Insbesondere Geräte der Nachrichtentechnik realisiert, die hochfrequente Digitalsignale beispielsweise für Signalübermittlungen des internets verarbeiten.

Vorteilhafte Weiterbildungen und Ausgestaltungen des erfindungsgemäßen mehrpoligen Steckverbinder, der erfindungsgemäßen Multilayerplatine sowie der erfindungsgemäßen Kombination aus dem mehrpoligen Steckverbinder und der Multilayerplatine ergeben sich aus den abhängigen Ansprüchen.

Eine Ausgestaltung des erfindungsgemäßen mehrpoligen Steckverbinders sieht vor, dass die in einer Kontaktelementreihe angeordneten Kontaktelemente zu Kontaktelementpaaren zusammengefasst sind.

Die Kontaktelementpaare führen bevorzugt Differenzsignale.

Eine vorteilhafte Ausgestaltung der Multilayerplatine zur Bestückung mit einem mehrpoligen Steckverbinder sieht vor, dass die in einer Reihe angeordneten Sacklochbohrungen zu nebeneinander angeordneten Paaren von Sacklöchern zusammengefasst sind, die zur Kontaktierung mit Anschlussstiften von in einer Kontaktelementreihe des Steckverbinders nebeneinander angeordneten Kontaktelementpaaren vorgesehen sind.

Sofern die Zusammenfassung von nebeneinander angeordneten Kontaktelementen zu Kontaktelementpaaren und/oder die Zusammenfassung von auf der Multilayerplatine nebeneinander angeordneten Sacklöchern zu Paaren von Sacklöchern vorgesehen ist, können die Paare bevorzugt mit Differenzsignalen beaufschlagt werden. Hierbei ergibt sich der wesentliche Vorteil, dass Signal-Laufzeitdifferenzen zwischen den Differenzsignalen wirksam vermieden werden.

Eine vorteilhafte Weiterbildung der erfindungsgemäßen Kombination des mehrpoligen Steckverbinders und der Multilayerplatine sieht vor, dass die Anschluss-Stifte die Tiefe der jeweiligen, den Anschluss-Stiften zugeordneten Sacklöcher wenigstens näherungsweise vollständig ausfüllen. Mit dieser Maßnahme wird eine hohe mechanische Stabilität des mit der Multilayerplatine kontaktierten Steckverbinders erzielt, der dadurch eine hohe Auszugskraft bereitstellen kann.

Eine andere vorteilhafte Weiterbildung sieht vor, dass die Kontaktelementpaare des Steckverbinders und/oder dass die den Kontaktelementpaaren zugeordneten Leiterbahnen der Multilayerplatine jeweils wenigstens näherungsweise mit einem vorgegebenen Wellenwiderstand realisiert sind. Der Wellenwiderstand Zw, der durch den Zusammenhang: Zw = Wurzel aus Induktivitätsbelag geteilt durch Kapazitätsbelag (bei verlustfreien Leitungen) gegeben ist, kann demnach durch die geometrischen Beziehungen der beteiligten elektrischen Leiter zueinander, also insbesondere des Abstands und der Leiterform sowie durch das Dielektrikum, also das Material des Steckverbinders beziehungsweise das Material der Multilayerplatine jeweils zwischen den beteiligten Leiterstrukturen gezielt auf den vorgegebenen Wert des Wellenwiderstands festgelegt werden. Einzelheiten zur Ermittlung des Kapazitätsbelags, des Induktivitätsbelags sowie des Wellenwiderstands können aus dem eingangs angegebenen Fachbuch von Meinke und Gundlach, insbesondere den Seiten 14, 18 und 165 entnommen werden.

Weitere vorteilhafte Weiterbildungen und Ausgestaltungen des erfindungsgemäßen mehrpoligen Steckverbinders zur Kontaktierung mit einer Multilayerplatine, der erfindungsgemäßen Multilayerplatine zur Bestückung mit dem erfindungsgemäßen mehrpoligen Steckverbinder sowie der erfindungsgemäßen Kombination aus einem mehrpoligen Steckverbinder und einer zur Bestückung mit dem mehrpoligen Steckverbinder vorgesehenen Multilayerplatine ergeben sich aus der folgenden Beschreibung und der zeichnerischen Darstellung von Ausführungsbeispielen der Erfindung.

Es zeigen
- Figur 1: eine Isometrische Ansicht von Kontaktelementen eines mehrpoligen, mit einer Multilayerplatine kontaktierten Steckverbinders gemäß dem Stand der Technik,
- Figur 2: eine Draufsicht auf Leiterbahnen der obersten Leiterbahnebene der in Figur 1 gezeigten Multilayerplatine,
- Figur 3: eine isometrische Ansicht eines Schnitts durch den in Figur 1 gezeigten Steckverbinder,
- Figur 4: einen Schnitt durch die in Figur 3 gezeigte Multilayerplatine,
- Figur 5: eine isometrische Ansicht von Kontaktelementen eines mehrpoligen, mit einer erfindungsgemäßen Multilayerplätine kontaktierten Steckverbinders gemäß der Erfindung,
- Figur 6: eine Draufsicht auf Leiterbahnen der obersten Leiterbahnebene der in Figur 5 gezeigten erfindungsgemäßen Multilayerplatine,
- Figur 7: eine isometrische Ansicht eines Schnitts durch die in Figur 5 gezeigte erfindungsgemäßen Multilayerplatine,
- Figur 8: einen Schnitt durch die in Figur 7 gezeigte erfindungsgemäße Multilayerplatine,
- Figur 9: eine isometrische Ansicht des vollständigen erfindungsgemäßen Steckverbinders, kontaktiert mit einer erfindungsgemäßen Multilayerplatine,
- Figur 10: eine isometrische Ansicht eines Segments des in Figur 9 gezeigten erfindungsgemäßen Steckverbinders,
- Figur 11: eine isometrische Ansicht eines Schnitts in vergrößerter Ansicht einer Multilayerplatine gemäß Figur 7 und
- Figur 12: eine isometrische Ansicht eines Schnitts durch eine erfindungsgemäße Multilayerplatine gemäß einer alternativen Ausgestaltung.

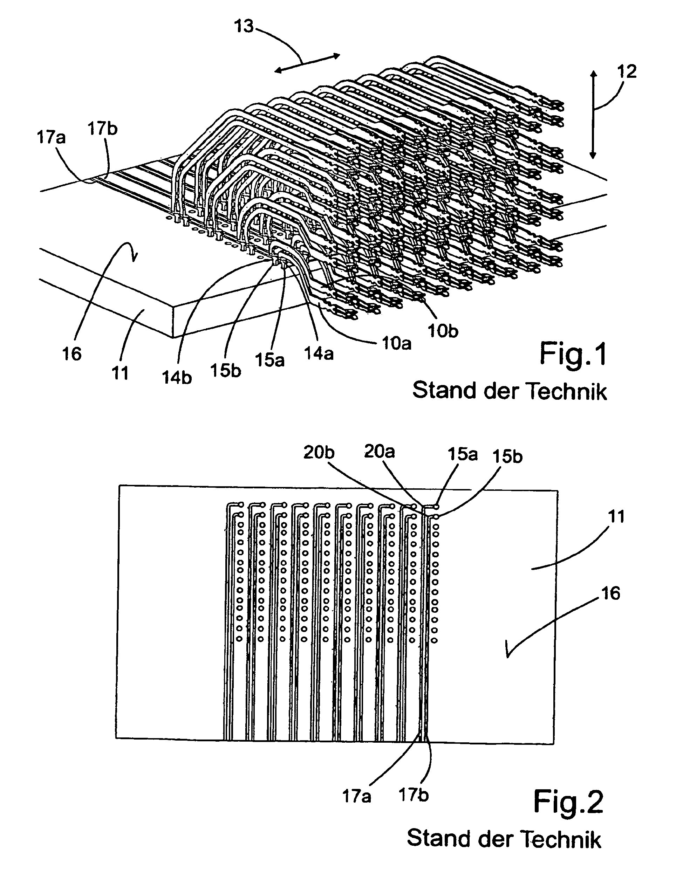

Figur 1 zeigt eine isometrische Ansicht von Kontaktelementen 10a, 10b eines mehrpoligen, mit einer Multilayerplatine 11 kontaktierten Steckverbinders gemäß dem Stand der Technik. Die Kontaktelemente 10a, 10b sind jeweils paarweise zusammengefasst. In Kontaktspaltenrichtung 12 sind vier Kontaktelementpaare angeordnet, wobei zehn Spalten in Kontaktreihenrichtung 13 vorgesehen sind. Die Anschluss-Stifte 14a, 14b der Kontaktelemente 10a, 10b sind in Bohrungen 15a, 15b der Multilayerplatine 11 verankert. Auf der obersten Leiterbahnebene 16 der Multilayerplatine 11, die mit der Oberfläche der Multilayerplatine 11 zusammenfällt, sind zwei Leiterbahnen 17a, 17b bezeichnet, die mit den Anschluss-Stiften 14a, 14b der Kontaktelemente 10a, 10b kontaktiert sind. Die Leiterbahnen 17a, 17b führen zu weiteren, nicht näher gezeigten Komponenten, die auf der Multilayerplatine 11 angeordnet sein können.

Figur 2 zeigt eine Draufsicht auf die oberste Leiterbahnebene 16 der in Figur 1 gezeigten Multilayerplatine 11, die der Oberfläche der Multilayerplatine 11 entspricht. Deutlich sichtbar sind Krümmungen 20a, 20b der zu den Bohrungen 15a, 15b führenden Leiterbahnen 17a, 17b. Die Krümmungen 20a, 20b sind erforderlich, um eine kreuzungsfreie Führung der Leiterbahnen 17a, 17b zu ermöglichen.

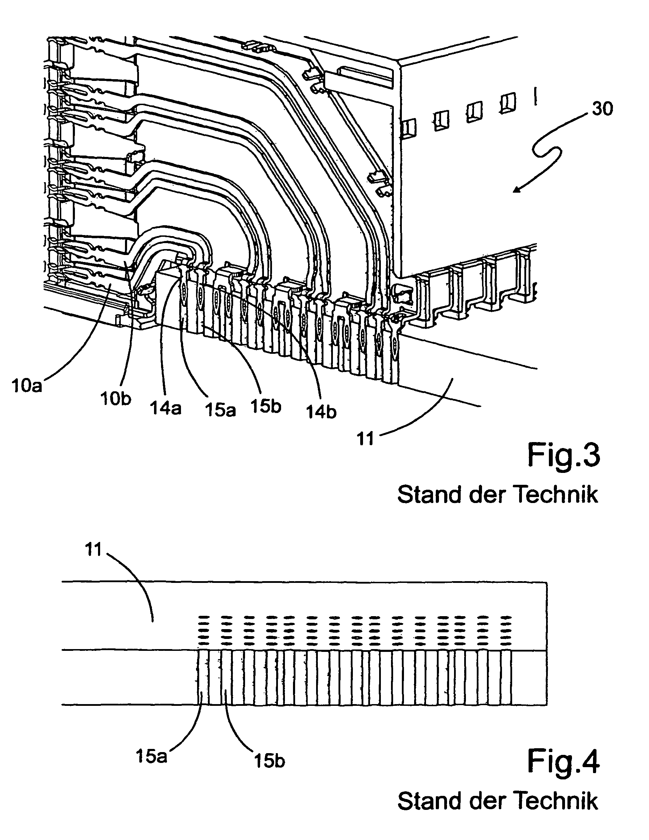

Figur 3 zeigt eine isometrische Ansicht eines Schnitts durch einen Steckverbinder 30 gemäß dem Stand der Technik mit den in Figur 1 gezeigten Kontaktelementen 10a, 10b. In Figur 3 ist die Verankerung der Anschluss-Stifte 14a, 14b der Kontaktelemente 10a, 10b in den Bohrungen 15a, 15b der Multilayerplatine 11 verdeutlicht. Demnach sind die Bohrungen 15a, 15b durch die Multilayerplatine 11 gebohrt. Dieser Sachverhalt ist in Figur 4, die einen Schnitt durch die Bohrungen 15a, 15b in der Multilayerplatine 11 darstellt, nochmals verdeutlicht.

Gemäß dem Stand der Technik kann die Multilayerplatine 11 nicht näher gezeigte Leiterbahnen aufweisen, die in unterschiedlichen Leiterbahnebenen verlaufen. Aufgrund der jeweils durch die Multilayerplatine 11 gebohrten Bohrungen 15a, 15b sind bei den in gegebenenfalls unterschiedlichen Leiterbahnebenen angeordneten Leiterbahnen eine Vielzahl von Krümmungen erforderlich, von denen beispielhaft die Krümmungen 20a, 20b der Leiterbahnen 17a, 17b in Figur 2 gezeigt sind.

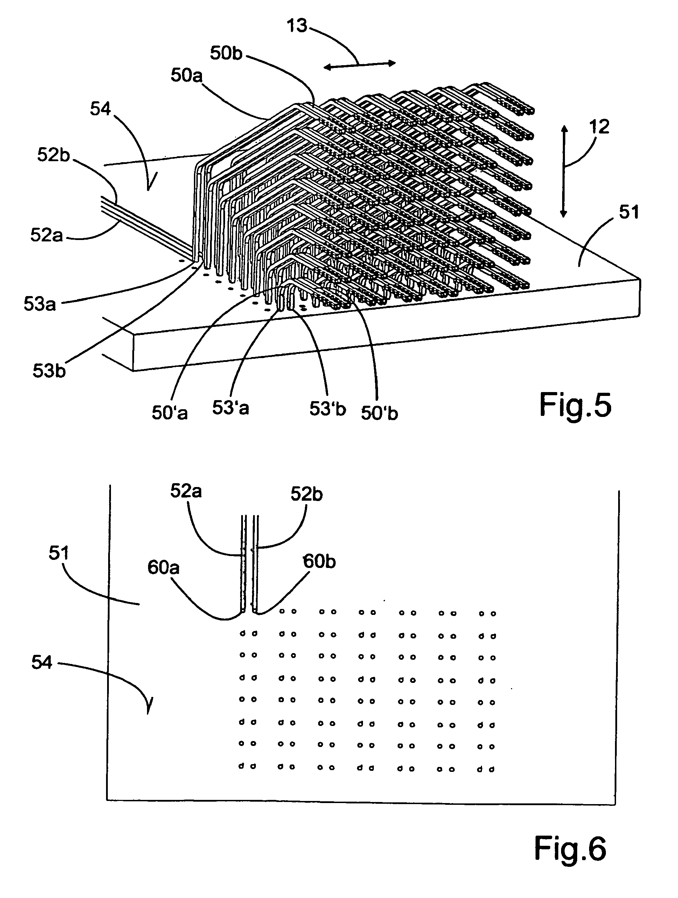

Bei der in Figur 5 gezeigten isometrischen Ansicht einer Vielzahl von Kontaktelementen 50a, 50b - 50'a, 50'b eines mehrpoligen, mit einer Multilayerplatine 51 kontaktierten Steckverbinders gemäß der Erfindung sind beispielhaft die Leiterbahnen 52a, 52b der Kontaktelementen 50a, 50b gezeigt, die in gerader Linie ohne Krümmungen von den in Figur 5 nicht sichtbaren Anschluss-Stiften 53a, 53b der Kontaktelemente 50a, 50b auf der obersten Leiterbahnebene 54 der Multilayerplatine 51 weggeführt sind, wobei die oberste Leiterbahnebene 54 exemplarisch zugleich der Oberfläche der erfindungsgemäßen Multilayerplatine 51 entspricht.

Die Kontaktelemente 50a, 50b - 50'a, 50'b sind paarweise jeweils in Kontaktreihenrichtung 13 angeordnet, wobei im gezeigten Ausführungsbeispiel sechs Kontaktelementpaare in Kontaktreihenrichtung 13 und acht Kontaktelementpaare in Kontaktspaltenrichtung 12 angeordnet sind. Diejenigen in Figur 5 gezeigten Teile, die mit den in den vorangegangenen Figuren gezeigten Teilen übereinstimmen, tragen jeweils dieselben Bezugszeichen. Dieselbe Vereinbarung gilt sinngemäß insbesondere auch für die folgenden Figuren.

Die in Figur 6 gezeigte Draufsicht auf die oberste Leiterbahnebene 54 der erfindungsgemäßen Multilayerplatine 51 verdeutlicht die in gerader Linie verlaufende Führung der Leiterbahnen 52a, 52b der zu den Bohrungen 60a, 60b führenden Leiterbahnen 52a, 52b, in welchen die Anschluss-Stifte 53a, 53b der Kontaktelemente 50a, 50b jeweils verankert sind.

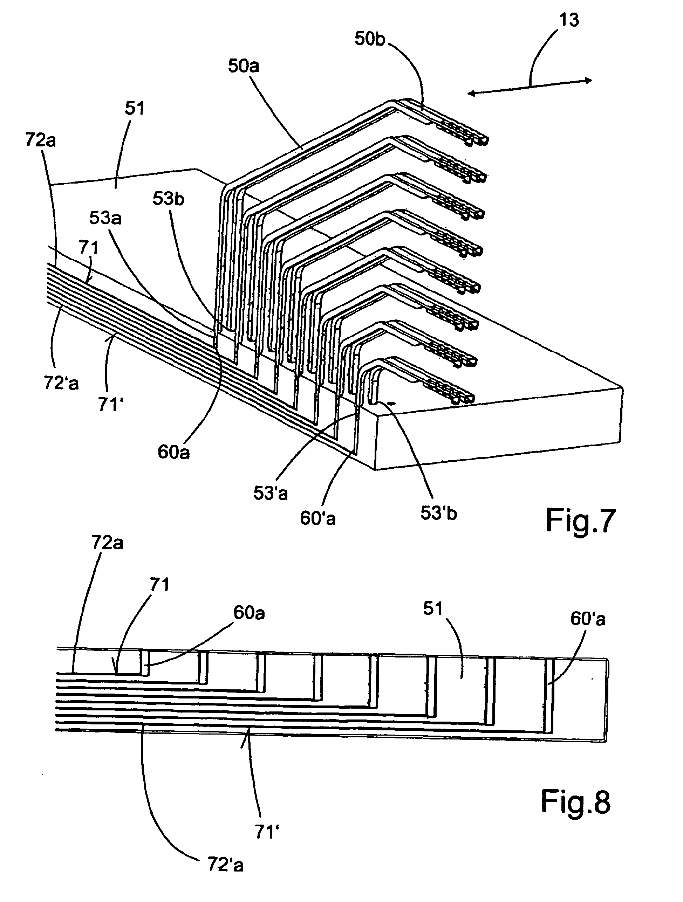

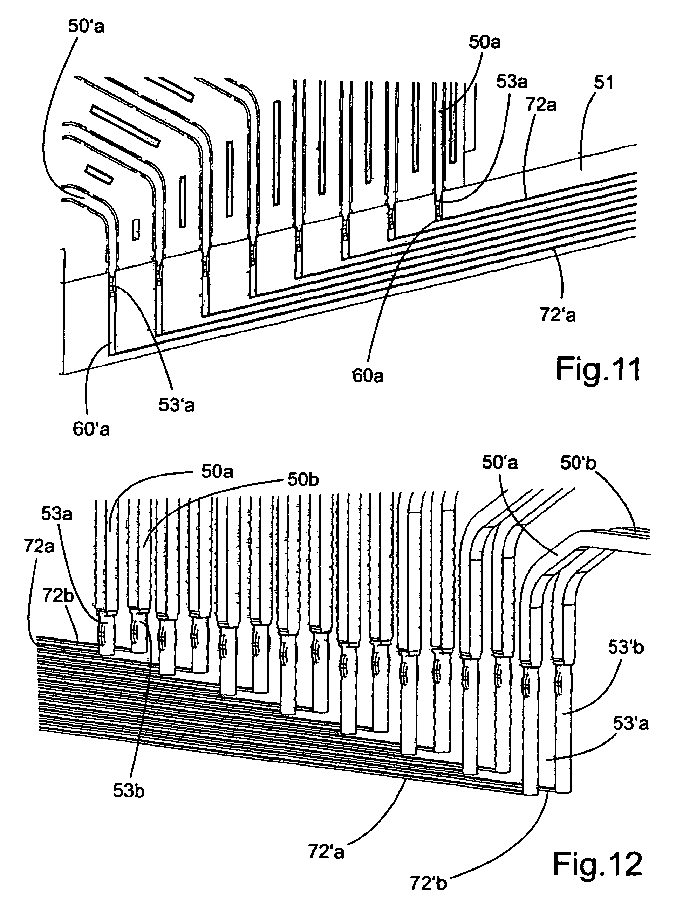

Die Möglichkeit zur geradlinig verlaufenden Führung der Leiterbahnen 52a, 52b wird anhand von Figur 7 deutlich, die eine Isometrische Ansicht eines Schnitts durch die erfindungsgemäße Multilayerplatine 51 zeigt. Anstelle der In den Figuren 5 und 6 gezeigten Leiterbahnen 52a, 52b auf der Oberfläche der Multilayerplatine 51 sollen beispielhaft nunmehr Leiterbahnen 72a, 72b - 72'a, 72'b (siehe auch Figur 12) vorgesehen sein, die innerhalb der Multilayerplatine 51 in unterschiedlichen Leitbahnebenen 71 - 71' liegen. Die Bohrungen 60a - 60'a in der Multilayerplatine 51 sind als Sacklochbohrungen ausgeführt, wobei die in den unterschiedlichen Leiterbahnebenen 71 - 71' geführten Leiterbahnen 72a, 72b - 72'a, 72'b zu den einzelnen Sacklochbohrungen 60a, 60b - 60'a, 60'b geführt sind. In Figur 7 sind aufgrund des Schnitts nur die Leiterbahnen 72a - 72b und die Sacklochbohrungen 60a - 60'a zu sehen. Die Längen der Anschluss-Stifte 53a, 53b - 53'a, 53'b der Kontaktelemente 50a, 50b - 50'a, 50'b sind auf die Sacklochbohrungen 60a, 60b - 60'a, 60'b derart abzustimmen, dass die Anschluss-Stifte 53a, 53b - 53'a, 53'b maximal die Länge der zugehörenden Sacklochbohrungen 60a, 60b - 60'a, 60'b aufweisen.

Figur 8, die einen Schnitt durch die in Figur 7 dargestellten Multilayerplatine 51 zeigt, verdeutlicht die Sacklochbohrungen 60a, 60b - 60'a, 60'b, wobei aufgrund des Schnitts nur die Sacklochbohrungen 60a - 60'a zu sehen sind, die in jeweils unterschiedlichen Leiterbahnebenen 71 - 71' enden, in welchen jeweils die Leiterbahnen 72a, 72b - 72'a, 72'b untergebracht sind, wovon die Leiterbahnen 72a - 72'a zu sehen sind. Die Leiterbahnen 72a, 72b - 72'a, 72'b stellen jeweils die Verbindungen zu den in den Sacklochbohrungen 60a, 60b - 60'a, 60'b vorhandenen, in Figur 8 nicht gezeigten Anschluss-Stiften 53a, 53b - 53'a, 53'b der Kontaktelemente 50a, 50b - 50'a, 50'b her, wobei in den Sacklochbohrungen 60a, 60b - 60'a, 60'b beispielsweise Metallisierungen vorhanden sind, die den elektrischen Kontakt zu den zu verlötenden oder vorzugsweise zu verpressenden Anschluss-Stiften 53a, 53b - 53'a, 53'b ermöglichen.

Die Figuren 7 und 8 zeigen die vorteilhafte Ausgestaltung der paarweisen Anordnung von Kontaktelementen 50a, 50b - 50'a, 50'b, wobei ein Kontaktelementpaar 50a, 50b - 50'a, 50'b vorzugsweise Differenzsignale führt. Dadurch, dass die beiden Kontaktelemente 50a, 50b - 50'a, 50'b eines Kontaktelementpaares nebeneinander in Kontaktreihenrichtung 13 angeordnet sind, kann sichergestellt werden, dass für die über ein Kontaktelementpaar 50a, 50b - 50'a, 50'b geführten Differenzsignale jeweils dieselbe Länge der Kontaktelemente 50a, 50b - 50'a, 50'b bis zu den Anschluss-Stiften 53a, 53b - 53'a, 53'b in den Sacklöchern 60a, 60b - 60'a, 60'b zur Verfügung steht. Damit wird ein vollständig symmetrischer Aufbau von Kontaktelementpaaren 50a, 50b - 50'a, 50'b erreicht, der eine Beaufschlagung der Kontaktelementpaaren 50a, 50b - 50'a, 50'b des erfindungsgemäßen Steckverbinders und/oder der erfindungsgemäßen Multilayerplatine und/oder der erfindungsgemäßen Kombination aus mehrpoligem Steckverbinder und Multilayerplatine mit sehr hohen Signalfrequenzen ermöglicht, bei denen nur äußerst geringe Signal-Laufzeitdifferenzen zwischen den Differenzsignalen auftreten dürfen. Es können hierbei digitale Signale im Bereich bis 40 GBit/s fehlerfrei übertragen werden.

Hierbei spielt die Vorgabe eines bestimmten Wellenwiderstands, beispielsweise 50 Ohm, für ein Kontaktelementpaar 50a, 50b - 50'a, 50'b ebenfalls eine Rolle, wobei der Wellenwiderstand, dessen Definition dem bereits erwähnten Fachbuch von Meincke und Gundlach entnommen werden kann, durch die geometrische Ausgestaltung der Kontaktelemente 50a, 50b - 50'a, 50'b, also deren Form und Abstand zueinander, sowie durch das zwischen dem Kontaktelementpaar 50a, 50b - 50'a, 50'b vorhandene Dielektrikum wesentlich beeinflusst wird. Der Wellenwiderstand kann jedoch auch innerhalb der Multilayerplatine 51 durch die entsprechenden Bemessungen der Leiterbahnen 72a, 72b - 72'a, 72'b mittels Vorgabe der genannten Kenngrößen eingestellt werden. Eine Minimierung der Signal-Laufzeitdifferenz wird auch im Bereich der Leiterbahnen 52a, 52b; 72a, 72b - 72'a, 72'b hauptsächlich durch die nunmehr mögliche geradlinige Führung der einzelnen Leiterbahnen 52a, 52b; 72a, 72b - 72'a, 72'b erzielt, wobei insbesondere die geradlinige und parallele Leiterbahnführung der zu einem Kontaktelementpaar 50a, 50b - 50'a, 50'b führenden Leiterbahnen 52a, 52b; 72a, 72b - 72'a, 72'b einen entscheidenden Beitrag zur Laufzeitminimierung liefert.

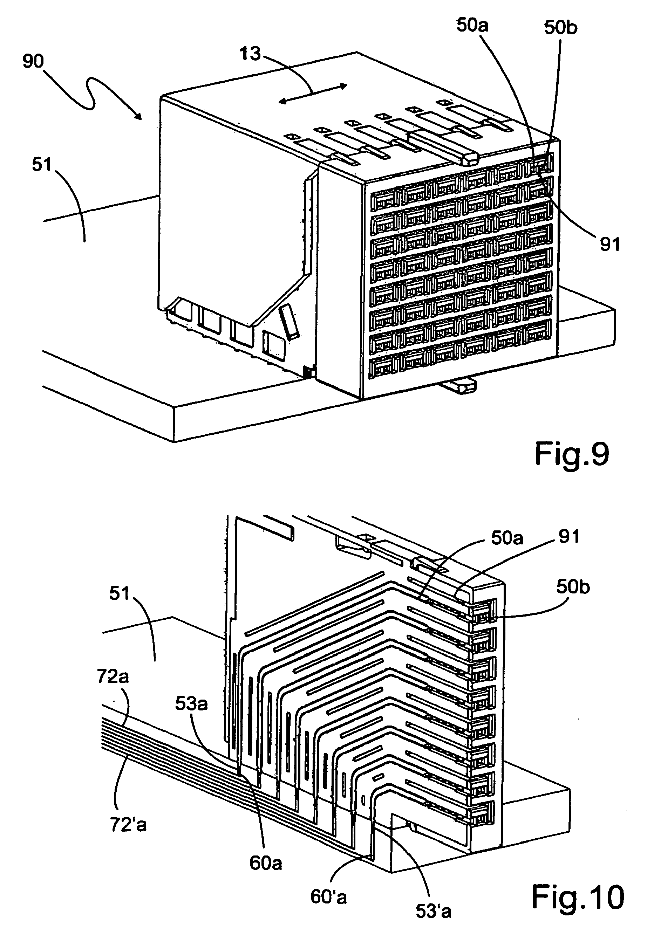

Figur 9 zeigt eine vollständige Ansicht des erfindungsgemäßen Steckverbinders 90, der mit der erfindungsgemäßen Multilayerplatine 51 kontaktiert ist. Bezeichnet ist ein Kontaktelementpaar 50a, 50b, das gemäß dem gezeigten Ausführungsbeispiel von einer Steckverbinderführung 91 zur Führung eines korrespondierenden Steckverbinders zumindest teilweise umgeben sein kann. Zur Verdeutlichung des Aufbaus des erfindungsgemäßen Steckverbinders 90 zeigt Figur 10 eine isometrische Ansicht eines Segments des in Figur 9 gezeigten Steckverbinders 90, wobei zusätzlich der Kontaktierungsbereich mit den in den Sacklochbohrungen 60 - 60' eingepressten Anschluss-Stiften 53a - 53'a sowie die zu den Sacklochbohrungen 60a - 60'a führenden Leiterbahnen 72a - 72'a zu sehen sind.

Figur 11 verdeutlicht eine Ausgestaltung, bei welcher die Sacklochbohrungen 60a - 60'a nur teilweise von den Anschluss-Stiften 53a - 53'a der Kontaktelemente 50a - 50'a ausgefüllt werden. Unter der Zugrundelegung der Abstufung der Sacklochbohrungen 60a - 60'a hinsichtlich ihrer Tiefe, wobei die größte Tiefe am Rand der Multilayerplatine 51 vorgegeben sein soll, wird bei diesem Ausführungsbeispiel der Anschluss-Stift 53a seine zugehörende Sacklochbohrung 60a nahezu vollständig ausfüllen, während der Anschluss-Stift 53'a des Kontaktelements 50'a seine zugehörende Sacklochbohrung 60'a nur unvollständig ausfüllt. Der Vorteil dieser Ausgestaltung liegt darin, dass die Anschluss-Stifte 53a, 53b - 53'a, 53'b der Kontaktelemente 50a, 50b - 50'a, 50'b jeweils identisch realisiert sein können.

Eine hierzu alternative Ausgestaltung ist in Figur 12 gezeigt, bei welcher die Anschluss-Stifte 53a, 53b - 53'a, 53'b jeweils mit einer Länge realisiert sind, welche die in Figur 12 nicht gezeigten Sacklochbohrungen 60a, 60b - 60'a, 60'b jeweils wenigstens näherungsweise vollständig ausfüllt. Der Vorteil bei dieser Ausgestaltung liegt darin, dass die mechanische Festigkeit das auf der erfindungsgemäßen Multilayerplatine 51 kontaktierten erfindungsgemäßen Steckverbinders 90 durch das nahezu vollständige Ausfüllen der Sacklochbohrungen 60a, 60b -60'a, 60'b erhöht ist, sodass das gesamte System eine hohe Auszugskraft bereitstellen kann. Die Darstellung in Figur 12 ist derart gewählt, dass die in den unterschiedlichen Leiterbahnebenen angeordneten Leiterbahnen von Kontaktelementpaaren dargestellt werden können, wovon exemplarisch die in der obersten Leiterbahnebene angeordneten Leiterbahnen 72a, 72b des Kontaktelementpaars 50a, 50b und die in der untersten Leiterbahnebene angeordneten Leiterbahnen 72'a, 72'b des Kontaktelementpaars 50'a, 50'b bezeichnet sind.

## Patentansprüche

1. Mehrpoliger Steckverbinder zur Kontaktierung mit einer Multilayerplatine (51), der eine Vielzahl von in Kontaktelementreihen (13) angeordneten Kontaktelementen (50a, 50b - 50'a, 50'b) aufweist, wobei die Anschluss-Stifte (53a, 53b - 53'a, 53'b) der in einer Kontaktelementreihe (13) liegenden Kontaktelemente (50a, 50b - 50'a, 50'b) jeweils gleich lang sind, **dadurch gekennzeichnet, dass** die Anschluss-Stifte (53a, 53b - 53'a, 53'b) der Kontaktelemente (50a, 50b - 50'a, 50'b) zur Kontaktierung mit in unterschiedlichen Leiterbahnebenen (71 - 71') vorgesehenen Leiterbahnen (52a, 52b; 72a, 72b - 72'a, 72'b) der Multilayerplatine (51) von Kontaktelementreihe (13) zu Kontaktelementreihe (13) in Stufen jeweils weniger lang enden.

2. Mehrpoliger Steckverbinder zur Kontaktierung mit einer Multilayerplatine (51) nach Anspruch 1, **dadurch gekennzeichnet, dass** die in einer Kontaktelementreihe (13) angeordneten Kontaktelemente (50a, 50b - 50'a, 50'b) zu Kontaktelementpaaren (50a, 50b - 50'a, 50'b) zusammengefasst sind.

3. Mehrpoliger Steckverbinder zur Kontaktierung mit einer Multilayerplatine (51) nach Anspruch 2, **dadurch gekennzeichnet, dass** die Kontaktelementpaare (50a, 50b - 50'a, 50'b) Differenzsignale führen.

4. Mehrpoliger Steckverbinder zur Kontaktierung mit einer Multilayerplatine (51) nach Anspruch 2, **dadurch gekennzeichnet, dass** die Kontaktelementpaare (50a, 50b - 50'a, 50'b) mit einem vorgegebenen Wellenwiderstand realisiert sind.

5. Multilayerplatine zur Bestückung mit einem mehrpoligen Steckverbinder (90), die in Reihen angeordnete Sacklochbohrungen (60a, 60b - 60'a, 60'b) zur Kontaktierung von Anschluss-Stiften (53a, 53b - 53'a, 53'b) der in Kontaktelementreihen (13) angeordneten Kontaktelemente (50a, 50b -50'a, 50'b) des mehrpoligen Steckverbinders (90) sowie in unterschiedlichen Leiterbahnebenen (71 - 71') vorgesehene Leiterbahnen (52a, 52b; 72a, 72b - 72'a, 72'b) aufweist, **dadurch gekennzeichnet, dass** die Sacklochbohrungen (60a, 60b - 60'a, 60'b) zur gezielten Kontaktierung der Anschluss-Stifte (53a, 53b - 53'a, 53'b) der in Kontaktelementreihen (13) angeordneten Kontaktelemente (50a, 50b - 50'a, 50'b) abgestuft von Reihe zu Reihe unterschiedlich tief sind und in unterschiedlichen Leiterbahnebenen (71 - 71') der Multilayerplatine (51) enden.

6. Multilayerplatine zur Bestückung mit einem mehrpoligen Steckverbinder (90) nach Anspruch 5, **dadurch gekennzeichnet, dass** die Sacklochbohrungen (60a, 60b - 60'a, 60'b) am Rand der Multilayerplatine (51) am tiefsten sind und dahinter in Stufen jeweils weniger tief enden.

7. Multilayerplatine zur Bestückung mit einem mehrpoligen Steckverbinder (90) nach Anspruch 5 oder 6, **dadurch gekennzeichnet, dass** die in einer Reihe angeordneten Sacklochbohrungen (60a, 60b - 60'a, 60'b) zu nebeneinander angeordneten Paaren von Sacklöchern (60a, 60b - 60'a, 60'b) zusammengefasst sind, die zur Kontaktierung mit Anschluss-Stiften (53a, 53b - 53'a, 53'b) von in einer Kontaktelementreihe (13) des Steckverbinders (90) nebeneinander angeordneten Kontaktelementpaaren (50a, 50b - 50'a, 50'b) vorgesehen sind.

8. Multilayerplatine zur Bestückung mit einem mehrpoligen Steckverbinder (90) nach Anspruch 7, **dadurch gekennzeichnet, dass** die den Paaren von Sacklöchern (60a, 60b - 60'a, 60'b) zugeordneten Leiterbahnen (52a, 52b; 72a, 72b - 72'a, 72'b) einen vorgegebenen Wellenwiderstand aufweisen.

9. Kombination aus mehrpoligem Steckverbinder (90) und Multilayerplatine (51), wobei der Steckverbinder (90) eine Vielzahl von in Kontaktelementreihen (13) angeordneten Kontaktelementen (50a, 50b - 50'a, 50'b) aufweist und wobei die Anschluss-Stifte (53a, 53b - 53'a, 53'b) der in einer Kontaktelementreihe (13) liegenden Kontaktelemente (50a, 50b - 50'a, 50'b) jeweils gleich lang sind, und die Multilayerplatine (51) in Reihen angeordnete Sacklochbohrungen (60a, 60b - 60'a, 60'b) zur Kontaktierung von Anschluss-Stiften (53a, 53b - 53'a, 53'b) der in den Kontaktelementreihen (13) angeordneten Kontaktelemente (50a, 50b -50'a, 50'b) des mehrpoligen Steckverbinders (90) sowie in unterschiedlichen Leiterbahnebenen (71 - 71') vorgesehene Leiterbahnen (52a, 52b; 72a, 72b - 72'a, 72'b) aufweist, **dadurch gekennzeichnet, dass** die Anschluss-Stifte (53a, 53b - 53'a, 53'b) der Kontaktelemente (50a, 50b - 50'a, 50'b) zur Kontaktierung mit in unterschiedlichen Leiterbahnebenen (71 - 71') vorgesehenen Leiterbahnen (52a, 52b; 72a, 72b - 72'a, 72'b) der Multilayerplatine (51) von Kontaktelementreihe (13) zu Kontaktelementreihe (13) in Stufen jeweils weniger lang enden und dass die Sacklochbohrungen (60a, 60b - 60'a, 60'b) zur gezielten Kontaktierung der Anschluss-Stifte (53a, 53b - 53'a, 53'b) der in Kontaktelementreihen (13) angeordneten Kontaktelemente (50a, 50b - 50'a, 50'b) abgestuft von Reihe zu Reihe unterschiedlich tief sind und in unterschiedlichen Leiterbahnebenen (71 - 71') der Multilayerplatine (51) enden.

10. Kombination aus mehrpoligem Steckverbinder (90) und Multilayerplatine (51) nach Anspruch 9, **dadurch gekennzeichnet, dass** die Anschluss-Stifte (53a, 53b - 53'a, 53'b) die zugehörenden Sacklochbohrungen (60a, 60b - 60'a, 60'b) wenigstens näherungsweise vollständig ausfüllen.

11. Kombination aus mehrpoligem Steckverbinder (90) und Multilayerplatine (51) nach Anspruch 9 oder 10, **dadurch gekennzeichnet, dass** die in einer Kontaktelementreihe (13) angeordneten Kontaktelemente (50a, 50b - 50'a, 50'b) zu Kontaktelementpaaren (50a, 50b - 50'a, 50'b) zusammengefasst sind.

12. Kombination aus mehrpoligem Steckverbinder (90) und Multilayerplatine (51) nach Anspruch 11, **dadurch gekennzeichnet, dass** die Kontaktelementpaare (50a, 50b - 50'a, 50'b) Differenzsignale führen.

13. Kombination aus mehrpoligem Steckverbinder (90) und Multilayerplatine (51) nach Anspruch 11 oder 12, **dadurch gekennzeichnet, dass** die Kontaktelementpaare (50a, 50b - 50'a, 50'b) mit einem vorgegebenen Wellenwiderstand realisiert sind.

## Claims

1. A multipolar connector for contacting a multilayer printed circuit board (51) which comprises a plurality of contact elements (50a, 50b - 50'a, 50'b) arranged in contact element rows (13), wherein the connecting pins (53a, 53b - 53'a, 53'b) of the contact elements (50a, 50b - 50'a, 50'b) disposed in a contact element row (13) are respectively equally long, **characterized in that** the connecting pins (53a, 53b - 53'a, 53'b) of the contact elements (50a, 50b - 50'a, 50'b) respectively end from contact element row (13) to contact element row (13) in a less long way in steps for contacting strip conductors (52a, 52b; 72a, 72b - 72'a, 72'b) of the multilayer circuit board (51) which are provided in different strip conductor planes (71 - 71').

2. A multipolar connector for contacting a multilayer printed circuit board (51) according to claim 1, **characterized in that** the contact elements (50a, 50b - 50'a, 50'b) arranged in a contact element row (13) are combined into contact element pairs (50a, 50b - 50'a, 50'b).

3. A multipolar connector for contacting a multilayer printed circuit board (51) according to claim 2, **characterized in that** the contact element pairs (50a, 50b - 50'a, 50'b) conduct differential signals.

4. A multipolar connector for contacting a multilayer printed circuit board (51) according to claim 2, **characterized in that** the contact element pairs (50a, 50b - 50'a, 50'b) are realized with a predetermined surge impedance.

5. A multilayer printed circuit board for component placement with a multipolar connector (90) which comprises blind-hole bores (60a, 60b - 60'a, 60'b) arranged in rows for contacting connecting pins (53a, 53b - 53'a, 53'b) of the contact elements (50a, 50b - 50'a, 50'b) of the multipolar connector (90) which are arranged in contact element rows (13), and comprises strip conductors (52a, 52b; 72a, 72b - 72'a, 72'b) provided in different strip conductor planes (71 - 71'), **characterized in that** the blind-hole bores (60a, 60b - 60'a, 60'b) are differently deep in a stepped manner from row to row for purposeful contacting of the connecting pins (53a, 53b - 53'a, 53'b) of the contact elements (50a, 50b - 50'a, 50'b) arranged in contact element rows (13) and end in different printed circuit board planes (71 - 71') of the multilayer printed circuit board (51).

6. A multilayer printed circuit board for component placement with a multipolar connector (90) according to claim 5, **characterized in that** the blind-hole bores (60a, 60b - 60'a, 60'b) are deepest at the edge of the multilayer printed circuit board (51) and end in a respectively less deep manner in steps thereafter.

7. A multilayer printed circuit board for component placement with a multipolar connector (90) according to claim 5 or 6, **characterized in that** the blind-hole bores (60a, 60b - 60'a, 60'b) arranged in a row are combined into pairs of blind-hole bores (60a, 60b - 60'a, 60'b) arranged adjacent to another, which pairs are provided for contacting connecting pins (53a, 53b - 53'a, 53'b) of contact element pairs (50a, 50b - 50'a, 50'b) arranged adjacent to one another in a contact element row (13) of the connector (90).

8. A multilayer printed circuit board for component placement with a multipolar connector (90) according to claim 7, **characterized in that** the strip conductors (52a, 52b; 72a, 72b - 72'a, 72'b) associated with the pairs of blind-hole bores (60a, 60b - 60'a, 60'b) have a predetermined surge impedance.

9. A combination of a multipolar connector (90) and a multilayer printed circuit board (51), wherein the connector (90) comprises a plurality of contact elements (50a, 50b - 50'a, 50'b) arranged in contact element rows (13), and wherein the connecting pins (53a, 53b - 53'a, 53'b) of the contact elements (50a, 50b - 50'a, 50'b) disposed in a contact element row (13) are respectively equally long, and the multilayer printed circuit board (51) comprises blind-hole bores (60a, 60b - 60'a, 60'b) arranged in rows for contacting connecting pins (53a, 53b - 53'a, 53'b) of the contact elements (50a, 50b - 50'a, 50'b) of the multipolar connector (90) which are arranged in the contact element rows (13), and comprises strip conductors (52a, 52b; 72a, 72b - 72'a, 72'b) provided in different strip conductor planes (71 - 71'), **characterized in that** the connecting pins (53a, 53b - 53'a, 53'b) of the contact elements (50a, 50b - 50'a, 50'b) respectively end from contact element row (13) to contact element row (13) in a less long way in steps for contacting strip conductors (52a, 52b; 72a, 72b - 72'a, 72'b) of the multilayer circuit board (51) provided in different strip conductors planes (71 - 71'), and that the blind-hole bores (60a, 60b - 60'a, 60'b) are differently deep in a stepped manner from row to row for purposeful contacting of the connecting pins (53a, 53b - 53'a, 53'b) of the contact elements (50a, 50b - 50'a, 50'b) arranged in contact element rows (13) and end in different printed circuit board planes (71 - 71') of the multilayer printed circuit board.

10. A combination of a multipolar connector (90) and a multilayer printed circuit board (51) according to claim 9, **characterized in that** the connecting pins (53a, 53b - 53'a, 53'b) at least approximately fully fill out the associated blind-hole bores (60a, 60b - 60'a, 60'b).

11. A combination of a multipolar connector (90) and a multilayer printed circuit board (51) according to claim 9 or 10, **characterized in that** the contact elements (50a, 50b - 50'a, 50'b) arranged in a contact element row (13) are combined into contact element pairs (50a, 50b - 50'a, 50'b).

12. A combination of a multipolar connector (90) and a multilayer printed circuit board (51) according to claim 11, **characterized in that** the contact element pairs (50a, 50b - 50'a, 50'b) conduct differential signals.

13. A combination of a multipolar connector (90) and a multilayer printed circuit board (51) according to claim 11 or 12, **characterized in that** the contact element pairs (50a, 50b - 50'a, 50'b) are realized with a predetermined surge impedance.

## Revendications

1. Connecteur à fiches multipolaire destiné à être mis en contact avec une platine multicouches (51) comportant plusieurs éléments de contact (50a, 50b, 50'a, 50'b) repartis en rangées (13) d'éléments de contact, les fiches de liaison (53a, 53b, 53'a, 53'b) des éléments de contact (50a, 50b, 50'a, 50'b) situés dans une rangée (13) d'éléments de contact étant respectivement de même longueur,
**caractérisé en ce que**
les fiches de liaison (53a, 53b, 53'a, 53'b) des éléments de contact (50a, 50b, 50'a, 50'b) destinés à être mis en contact avec des pistes conductives (52a, 52b, 72a, 72b, 72'a, 72'b) de la platine multicouches (51) situées dans différents plans de pistes conductives (71, 71') sont respectivement graduellement de moins en moins longs d'une rangée (13) d'éléments de contact à une autre.

2. Connecteur à fiches multipolaire destiné à être mis en contact avec une platine multicouches (51) conforme à la revendication 1,
**caractérisé en ce que**
les éléments de contact (50a, 50b, 50'a, 50'b) disposés dans une rangée (13) d'éléments de contact sont rassemblés en paires d'éléments de contact (50a, 50b, 50'a, 50'b).

3. Connecteur à fiches multipolaire destiné à être mis en contact avec une platine multicouches (51) conforme à la revendication 2,
**caractérisé en ce que**
les paires d'éléments de contact (50a, 50b, 50'a, 50'b) transmettent des signaux différentiels.

4. Connecteur à fiches multipolaire destiné à être mis en contact avec une platine multicouches (51) conforme à la revendication 2,
**caractérisé en ce que**
les paires d'éléments de contact (50a, 50b, 50'a, 50'b) sont réalisées avec une impédance caractéristique prédéfinie.

5. Platine multicouches destinée à être équipée d'un connecteur à fiches multipolaire (90) comportant des trous borgnes (60a, 60b ; 60'a, 60'b) disposés en rangée destinés à être mis en contact avec des fiches de liaison (53a, 53b, 53'a, 53'b) des éléments de contact (50a, 50b, 50'a, 50'b) disposés en rangées (13) d'éléments de contact du connecteur à fiches multipolaire (90) ainsi que des pistes conductives (52a, 52b, 72a, 72b, 72'a, 72'b) prévues dans différents plans de pistes conductives (71, 71'),
**caractérisée en ce que**
les trous borgnes (60a, 60b, 60'a, 60'b) ont graduellement une profondeur différente de rangée en rangée pour permettre une mise en contact appropriée avec les fiches de liaison (53a, 53b, 53'a, 53'b) des éléments de contact (50a, 50b, 50'a, 50'b) disposés en rangées (13) d'éléments de contact et se terminent dans des plans de pistes conductives (71, 71') différents de la platine multicouches (51).

6. Platine multicouches destinée à être équipée d'un connecteur à fiches multipolaire (90) conforme à la revendication 5,
**caractérisée en ce que**
les trous borgnes (60a, 60b, 60'a, 60'b) sont le plus profonds au bord de la platine multicouches (51) et sont respectivement graduellement moins profonds en arrière de celui-ci.

7. Platine multicouches destinée à être équipée d'un connecteur à fiches multipolaire (90) conforme à la revendication 5 ou 6,
**caractérisée en ce que**
les trous borgnes (60a, 60b, 60'a, 60'b) situés dans une rangée, sont rassemblés en paires de trous borgnes (60a, 60b, 60'a, 60'b) disposés côte-à-côte destinés à être mis en contact avec des fiches de liaison (53a, 53b, 53'a, 53'b) de paires d'éléments de contact (50a, 50b, 50'a, 50'b) disposés côte-à-côte dans une rangée de contact (13) du connecteur à fiches (90).

8. Platine multicouches destinée à être équipée d'un connecteur à fiches multipolaire (90) conforme à la revendication 7,
**caractérisée en ce que**
les pistes conductives (52a, 52b, 72a, 72b, 72'a, 72'b) associées aux paires de trous borgnes (60a, 60b, 60'a, 60'b) présentent une impédance caractéristique prédéfinie.

9. Combinaison d'un connecteur à fiches multipolaire (90) et d'une platine multicouches (51) dans laquelle le connecteur à fiches (90) comporte plusieurs éléments de contact (50a, 50b, 50'a, 50'b) disposés en rangées (13) d'éléments de contact, les fiches de liaison (53a, 53b, 53'a, 53'b) des éléments de contact (50a, 50b, 50'a, 50'b) situés dans une rangée (13) d'éléments de contact ont respectivement la même longueur, et la platine multicouches (51) comporte des trous borgnes (60a, 60b, 60'a, 60'b) disposés en rangées destinés à être mis en contact avec des fiches de liaison (53a, 53b, 53'a, 53'b) des éléments de contact (50a, 50b,50'a, 50'b) disposés en rangées d'éléments de contact (13) du connecteur à fiches multipolaire (90) ainsi que des pistes conductives (52a, 52b, 72a, 72b, 72'a, 72'b) situées dans différents plans de pistes conductives (71, 71'),
**caractérisée en ce que**
les fiches de liaison (53a, 53b, 53'a, 53'b) des éléments de contact (50a, 50b, 50'a, 50'b) destinés à être mis en contact avec des pistes conductives (52a, 52b, 72a, 72b, 72'a, 72'b) de la platine multicouches (51) situées dans différents plans de pistes conductives (71, 71') sont respectivement graduellement de moins en moins longs d'une rangée (13) d'éléments de contact à une autre, et
les trous borgnes (60a, 60b, 60'a, 60'b) ont graduellement une profondeur différente de rangée en rangée pour permettre une mise en contact appropriée avec les fiches de liaison (53a, 53b, 53'a, 53'b) des éléments de contact (50a, 50b, 50'a, 50'b) disposés en rangées (13) d'éléments de contact et se terminent dans des plans de pistes conductives (71, 71') différents de la platine multicouches (51).

10. Combinaison d'un connecteur à fiches multipolaire (90) et d'une platine multicouches (51) conforme à la revendication 9,
**caractérisée en ce que**
les fiches de liaison (53a, 53b, 53'a, 53'b) remplissent au moins approximativement complètement les trous borgnes correspondants (60a, 60b, 60'a, 60'b).

11. Combinaison d'un connecteur à fiches multipolaire (90) et d'une platine multicouches (51) conforme à la revendication 9 ou 10,
**caractérisée en ce que**
les éléments de contact (50a, 50b, 50'a, 50'b) disposés dans une rangée d'éléments de contact (13) sont rassemblés en paires d'éléments de contact (50a, 50b, 50'a, 50'b).

12. Combinaison d'un connecteur à fiches multipolaire (90) et d'une platine multicouches (51) conforme à la revendication 11,
**caractérisée en ce que**
les paires d'éléments de contact (50a, 50b, 50'a, 50'b) transmettent des signaux différentiels.

13. Combinaison d'un connecteur à fiches multipolaire (90) et d'une platine multicouches (51) conforme à la revendication 11 ou 12,
**caractérisée en ce que**
les paires d'éléments de contact (50a, 50b, 50'a, 50'b) sont réalisées avec une impédance caractéristique prédéfinie.
